# EUROPEAN PATENT SPECIFICATION

(11) **EP 4 285 094 B1**
(45) Date of publication and mention of the grant of the patent: **10.12.2025**
(21) Application number: 22706514.1
(22) Date of filing: 01.02.2022
(51) Int. Cl.: G01M 17/06, G06F 30/20, G06N 5/04, B60W 30/02, B60W 60/00

(54) **VEHICLE TRAJECTORY ASSESSMENT**
BEURTEILUNG DER FAHRZEUGTRAJEKTORIE
ÉVALUATION DE TRAJECTOIRE DE VÉHICULE

(30) Priority: 02.02.2021 GB 202101409
(43) Date of publication of application: 06.12.2023
(73) Proprietor: Five AI Limited, Cambridge CB1 2JH (GB)
(72) Inventor: WURMSDOBLER, Peter, Bristol BS1 6QS (GB)
(74) Representative: Page White Farrer
(86) International application number: PCT/EP2022/052344
(87) International publication number: WO 2022/167416

(56) References cited:
- EP-A1- 2 331 929
- EP-B1- 2 331 929
- CN-A- 107 941 533
- CN-A- 110 231 179
- CN-A- 110 411 766
- US-A1- 2020 103 912

## Description

### Technical Field

The present disclosure pertains to methods for assessing vehicle trajectories in real or simulated scenarios, and computer programs and systems for implementing the same. Example applications include ADS (Autonomous Driving System) and ADAS (Advanced Driver Assist System) performance testing.

### Background

There have been major and rapid developments in the field of autonomous vehicles. An autonomous vehicle (AV) is a vehicle which is equipped with sensors and control systems which enable it to operate without a human controlling its behaviour. An autonomous vehicle is equipped with sensors which enable it to perceive its physical environment, such sensors including for example cameras, radar and lidar. Autonomous vehicles are equipped with suitably programmed computers which are capable of processing data received from the sensors and making safe and predictable decisions based on the context which has been perceived by the sensors. An autonomous vehicle may be fully autonomous (in that it is designed to operate with no human supervision or intervention, at least in certain circumstances) or semi-autonomous. Semi-autonomous systems require varying levels of human oversight and intervention, such systems including Advanced Driver Assist Systems and level three Autonomous Driving Systems. There are different facets to testing the behaviour of the sensors and control systems aboard a particular autonomous vehicle, or a type of autonomous vehicle.

Safety is an increasing challenge as the level of autonomy increases. In autonomous driving, the importance of guaranteed safety has been recognized. Guaranteed safety does not necessarily imply zero accidents, but rather means guaranteeing that some minimum level of safety is met in defined circumstances. It is generally assumed this minimum level of safety must significantly exceed that of human drivers for autonomous driving to be viable.

Patent document CN110411766 teaches a time domain analysis and frequency domain analysis of serpentine movement of a railway bogie. According to characteristic values obtained by the analysis, an acceleration variation law and distribution of a train during normal operations can be analyzed then an instability classification model can be constructed. Patent document CN107941533 teaches an instability detection sensor disposed on a bogie for real-time acquisition of a transverse vibration signal. An instability sensor takes the form of lateral acceleration sensors.

Patent document US2020/103912 describes a method for improving the stability of an autonomous vehicle by measuring the lateral offset sequence of a vehicle and when this offset exceed a threshold, determining a control input parameter and use the obtained data to train the driving model.

### Summary

Lateral stability is an important concept in ADS and ADAS technology. For example, automated lane keeping is a rapidly developing area of technology. In this context, it is generally not sufficient for an automated system to merely keep a vehicle within a target lane; behaviours that risk confusion to other drivers should also be avoided. In particular, the need to maintain a stable lateral position with a lane, where possible, has been recognized, and failure to do so risks confusing other drivers. However, less consideration has been given to practical implementations of this qualitative requirement in the context of testing and trajectory assessment.

Aspects herein provide a lateral stability assessor that can be applied in a vehicular context. A key application of the present lateral stability assessor is performance testing for AV systems over many different scenarios (real and/or simulated), in which the ability of a vehicle agent to maintain a stable lateral position may be repeatedly tested in a structured fashion.

A first aspect herein provides a method of assessing lateral stability of a moving vehicle in a real or simulated driving scenario, the method comprising: determining a time-varying lateral position signal for the moving vehicle; computing an evolving frequency spectrum of the time-varying lateral position signal over a moving window across the time-varying lateral position signal; and analysing the evolving frequency spectrum to extract a lateral stability signal that indicates an extent to which the moving vehicle is maintaining a stable lateral position.

In a simulation context, the method may be applied to a simulated trace of an agent, e.g. in order to test compliance of the agent with a defined lateral stability requirement. For example, a simulator may provide the simulated trace as part of a scenario "ground truth" (the known state of the simulated scenario over time). The method can be applied in real-time as the scenario is running in the simulator, or offline at any time after the scenario has completed and the trace has been generated.

When applied to real-world data, ground truth (or pseudo ground truth) may be derived via manual, automated or semi-automated annotation of captured scenario data.

The method can also be usefully applied in other contexts, both offline and online (including online within an AV stack for assessing the stability of a vehicle's own trajectory and/or the trajectory of another agent, potentially in real-time).

In embodiments, said analysing may comprise applying peak detection to the evolving frequency spectrum, with the lateral stability signal determined based on an amplitude of any detected peak(s).

For example, said analysing may comprise detecting a noise floor of the evolving frequency spectrum, with the lateral stability signal determined based on the amplitude of any detected peak(s) above the noise floor.

For example, the noise floor may be determined based on a noise portion of the spectrum above a frequency threshold. Physical characteristics of the moving vehicle mean peaks are unlikely to occur above a certain frequency; therefore, a noise portion of the spectrum above a certain frequency can be assumed to contain only noise. In a simulation context, those physical characteristics may be encoded in a vehicle dynamics model on which the lateral position signal depends.

The scenario may be simulated, and the lateral position signal may be dependent on a vehicle dynamics model.

The lateral stability signal may be a numerical signal that quantifies the extent to which the moving vehicle is maintaining a stable lateral position.

For example, the lateral position signal may be determined as the sum of the amplitude of each peak above the noise floor, i.e. the sum of (peak_amplitude - noise_floor) over all peak(s) (if any).

Peaks may be detected above a multiple of the noise floor. That multiple may be a configurable parameter.

The method may comprise applying a threshold to the numerical lateral stability signal at multiple time steps of the scenario, in order to assess compliance with a lateral stability requirement at each of the multiple time steps.

The result may be a categorical (e.g. binary pass/fail) lateral stability signal, indicating compliance or non-compliance with the lateral stability requirement at each time step.

The threshold may be a configurable parameter.

The time-varying lateral position signal may be a digital signal. In this context, one or more digital signal processing techniques may be used to compute the lateral stability signal more efficiently, without compromising its information content. Those techniques may leverage understanding of the physical properties of the moving vehicle (whether real or modelled).

For example, the sample rate of the digital time-varying lateral position signal may be set based on a response time of the moving vehicle. In a simulation context, the response time may be determined by the vehicle dynamics model.

Such embodiments exploit the fact that, realistically, a vehicle can only respond so quickly to changes in steering angle. This, in turn, imposes a de facto upper frequency limit on non-noise spectral content (e.g. this might be of the order one Hertz or a few Hertz for certain vehicles). In accordance with the Nyquist theorem, a digital signal can fully capture frequency content up to its Nyquist frequency (one half its sample rate). This knowledge can, in turn, be used to set the sample rate at an appropriately low level to avoid excessive and unnecessary high-frequency content that will almost certainly be exclusively noise (in a simulation context, this may be lower than the rate at which a state of the simulated scenario is updated).

In embodiments in which a noise portion of the spectrum is used to measure the noise floor, the sample rate may be set sufficiently high so as to provide the noise portion (an upper portion of the available spectrum assumed to contain only noise).

In embodiments, the sample rate of the digital time-varying lateral position signal may be of the order of 10Hz (order of magnitude).

For example, a sample rate of approximately 10Hz allows frequency content up to around 5Hz to be fully captured, with sufficient "headroom" in which the noise floor can be measured (e.g. the noise portion could be taken as approximately 2.5Hz to 5Hz, assumed to contain only noise, which will generally hold true for a typical vehicle).

As well as limiting the likely frequency content of the spectrum, the physical characteristics of the vehicle mean that whatever lower-frequency content is present will change relatively slowly. In addition or as an alternative to restricting the sample rate, the rate at which the evolving frequency spectrum is re-computed may also be reduced.

For example, the evolving frequency spectrum may be re-computed at a rate less than a sample rate of the time-varying lateral position signal.

The evolving spectrum may be re-computed at a rate of the order of 1Hz (once-per-second order of magnitude).

A zero-padded raw lateral stability signal may be computed from the evolving frequency spectrum, and the zero-padded raw lateral stability signal may be computed by filtering the zero-padded raw lateral stability signal. This is a form of upsampling, to bring the evolving frequency signal back (or closer to) the original sample rate.

The filtering may bidirectional. This maintains temporal alignment between the filtered signal and the original signal.

The time-varying lateral position signal may be computed by downsampling a higher-fidelity lateral position signal.

In that event, the sample rate of the zero-padded raw lateral stability signal may match the downsampled time-varying lateral position signal, and the lateral stability signal may be upsampled to match the sample rate of the higher-fidelity lateral position signal. In this case, there are two stages of upsampling - the zero padding and filtering, followed by the (further) upsampling (which may also use zero padding and filtering).

The moving window may, for example, be a moving Hamming window. However, this is merely an example and other windowing functions may be used.

The sample rate of the digital time-varying lateral position signal and/or the rate at which the frequency spectrum is recomputed may be configurable parameter(s). This allows one or both of those parameters to be optimized for any class of vehicle physics that is of interest (e.g. higher rates for lighter and more agile vehicles vs. lower rates for heaver and less responsive vehicles).

A length of the window used to compute the evolving frequency spectrum may be a configurable parameter.

The method may be applied to test at least part of an autonomous vehicle stack in control of the moving vehicle.

The method may comprise using the lateral stability signal to identify and mitigate a performance issue in said at least part of the autonomous vehicle stack.

The method may comprise providing an output for assessing performance of said at least part of the autonomous vehicle stack with respect to a lateral stability requirement.

Further aspects herein provide a lateral stability assessor configured to implement the method of the first aspect or any embodiment thereof, and a computer system comprising a lateral position extractor configured to provide a time-varying lateral position signal, and the lateral stability assessor.

The lateral stability assessor may be in the form of executable program instructions stored embodied in non-transitory media.

### Brief Description of Figures

For a better understanding of the present disclosure, and to show how embodiments of the same may be carried into effect, reference is made by way of example only to the following figures in which:
Figure 1A shows a schematic function block diagram of an autonomous vehicle stack;
Figure 1B shows a schematic overview of an autonomous vehicle testing paradigm;
Figure 1C shows a schematic block diagram of a scenario extraction pipeline;
Figure 2 shows a schematic block diagram of a testing pipeline;
Figure 2A shows further details of a possible implementation of the testing pipeline;
Figure 3A shows a schematic block diagram of lateral position extractor and lateral stability assessor within a test oracle;
Figure 3B shows an example of a lane-driving scenario;
Figure 4 shows an example implementation of a lateral stability assessor;
Figure 5 shows an example implementation of a computation component for computing a lateral stability metric;
Figure 6A shows an example of zero padded raw lateral stability signal in one implementation; and
Figure 6B shows an example of a smooth lateral stability signal obtained via bidirectional filtering of a zero padded raw lateral stability signal;
Figure 7 shows an example output of a lateral stability assessor;
Figure 8A shows a schematic block diagram of a visualization component for rendering a graphical user interface on which test results are displayed;
Figure 8B shows a view available within a graphical user interface.

### Detailed Description

Herein, a "scenario" can be real or simulated and involves an ego agent (an ego vehicle or other mobile robot) moving within an environment (e.g. within a particular road layout), typically in the presence of one or more other agents (other vehicles, pedestrians, cyclists, animals etc.). A "trace" is a history of an agent's (or actor's) location and motion over the course of a scenario. There are many ways a trace can be represented. Trace data will typically include spatial and motion data of an agent within the environment. The term is used in relation to both real scenarios (with physical traces) and simulated scenarios (with simulated traces). The following description considers simulated scenarios but the same techniques can be applied to assess performance on real-world scenarios.

In a simulation context, the term scenario may be used in relation to both the input to a simulator (such as an abstract scenario description) and the output of the simulator (such as the traces). It will be clear in context which is referred to.

A typical AV stack includes perception, prediction, planning and control (sub)systems. The term "planning" is used herein to refer to autonomous decision-making capability (such as trajectory planning) whilst "control" is used to refer to the generation of control signals for carrying out autonomous decisions. The extent to which planning and control are integrated or separable can vary significantly between different stack implementations - in some stacks, these may be so tightly coupled as to be indistinguishable (e.g. such stacks could plan in terms of control signals directly), whereas other stacks may be architected in a way that draws a clear distinction between the two (e.g. with planning in terms of trajectories, and with separate control optimizations to determine how best to execute a planned trajectory at the control signal level). Unless otherwise indicated, the planning and control terminology used herein does not imply any particular coupling or separation of those aspects. An example form of AV stack will now be described in further detail, to provide relevant context to the subsequent description.

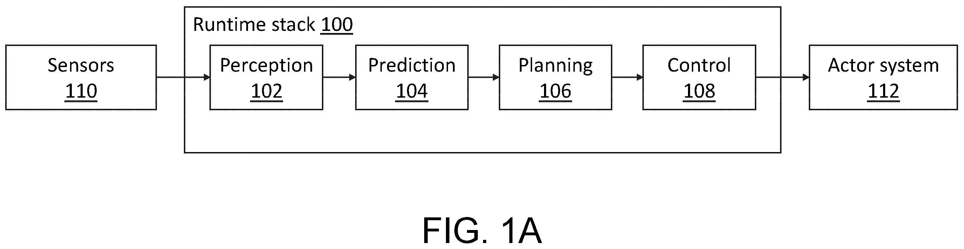

Figure 1A shows a highly schematic block diagram of a runtime stack 100 for an autonomous vehicle (AV), also referred to herein as an ego vehicle (EV). The run time stack 100 is shown to comprise a perception system 102, a prediction system 104, a planner 106 and a controller 108.

In a real-world context, the perception system 102 would receive sensor outputs from an on-board sensor system 110 of the AV, and use those sensor outputs to detect external agents and measure their physical state, such as their position, velocity, acceleration etc. The on-board sensor system 110 can take different forms but generally comprises a variety of sensors such as image capture devices (cameras/optical sensors), lidar and/or radar unit(s), satellite-positioning sensor(s) (GPS etc.), motion/inertial sensor(s) (accelerometers, gyroscopes etc.) etc. The onboard sensor system 110 thus provides rich sensor data from which it is possible to extract detailed information about the surrounding environment, and the state of the AV and any external actors (vehicles, pedestrians, cyclists etc.) within that environment. The sensor outputs typically comprise sensor data of multiple sensor modalities such as stereo images from one or more stereo optical sensors, lidar, radar etc. Sensor data of multiple sensor modalities may be combined using filters, fusion components etc.

The perception system 102 typically comprises multiple perception components which co-operate to interpret the sensor outputs and thereby provide perception outputs to the prediction system 104.

In a simulation context, depending on the nature of the testing - and depending, in particular, on where the stack 100 is "sliced" for the purpose of testing - it may or may not be necessary to model the on-board sensor system 100. With higher-level slicing, simulated sensor data is not required therefore complex sensor modelling is not required.

The perception outputs from the perception system 102 are used by the prediction system 104 to predict future behaviour of external actors (agents), such as other vehicles in the vicinity of the AV.

Predictions computed by the prediction system 104 are provided to the planner 106, which uses the predictions to make autonomous driving decisions to be executed by the AV in a given driving scenario. The inputs received by the planner 106 would typically indicate a drivable area and would also capture predicted movements of any external agents (obstacles, from the AV's perspective) within the drivable area. The driveable area can be determined using perception outputs from the perception system 102 in combination with map information, such as an HD (high definition) map.

A core function of the planner 106 is the planning of trajectories for the AV (ego trajectories), taking into account predicted agent motion. This may be referred to as trajectory planning. A trajectory is planned in order to carry out a desired goal within a scenario. The goal could for example be to enter a roundabout and leave it at a desired exit; to overtake a vehicle in front; or to stay in a current lane at a target speed (lane following). The goal may, for example, be determined by an autonomous route planner (not shown).

The controller 108 executes the decisions taken by the planner 106 by providing suitable control signals to an on-board actor system 112 of the AV. In particular, the planner 106 plans trajectories for the AV and the controller 108 generates control signals to implement the planned trajectories. Typically, the planner 106 will plan into the future, such that a planned trajectory may only be partially implemented at the control level before a new trajectory is planned by the planner 106.

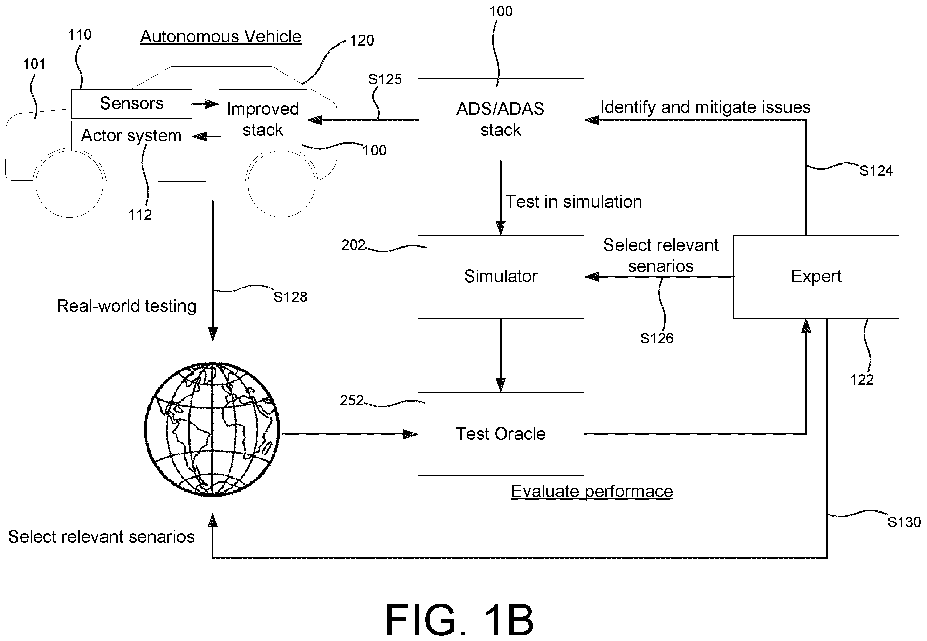

Figure 1B shows a highly schematic overview of a testing paradigm for autonomous vehicles. An ADS/ADAS stack 100, e.g. of the kind depicted in Figure 1A, is subject to repeated testing and evaluation in simulation, by running multiple scenario instances in a simulator 202, and evaluating the performance of the stack 100 (and/or individual subs-stacks thereof) in a test oracle 252. The output of the test oracle 252 is informative to an expert 122 (team or individual), allowing them to identify issues in the stack 100 and modify the stack 100 to mitigate those issues (S124). The results also assist the expert 122 in selecting further scenarios for testing (S126), and the process continues, repeatedly modifying, testing and evaluating the performance of the stack 100 in simulation. The improved stack 100 is eventually incorporated (S125) in a real-world AV 101, equipped with a sensor system 110 and an actor system 112. The improved stack 100 typically includes program instructions (software) executed in one or more computer processors of an on-board computer system of the vehicle 101 (not shown). The software of the improved stack is uploaded to the AV 101 at step S125. Step S125 may also involve modifications to the underlying vehicle hardware. On board the AV 101, the improved stack 100 receives sensor data from the sensor system 110 and outputs control signals to the actor system 112. Real-world testing (S128) can be used in combination with simulation-based testing. For example, having reached an acceptable level of performance through the process of simulation testing and stack refinement, appropriate real-world scenarios may be selected (S130), and the performance of the AV 101 in those real scenarios may be captured and similarly evaluated in the test oracle 252.

Scenarios can be obtained for the purpose of simulation in various ways, including manual encoding. The system is also capable of extracting scenarios for the purpose of simulation from real-world runs, allowing real-world situations and variations thereof to be re-created in the simulator 202.

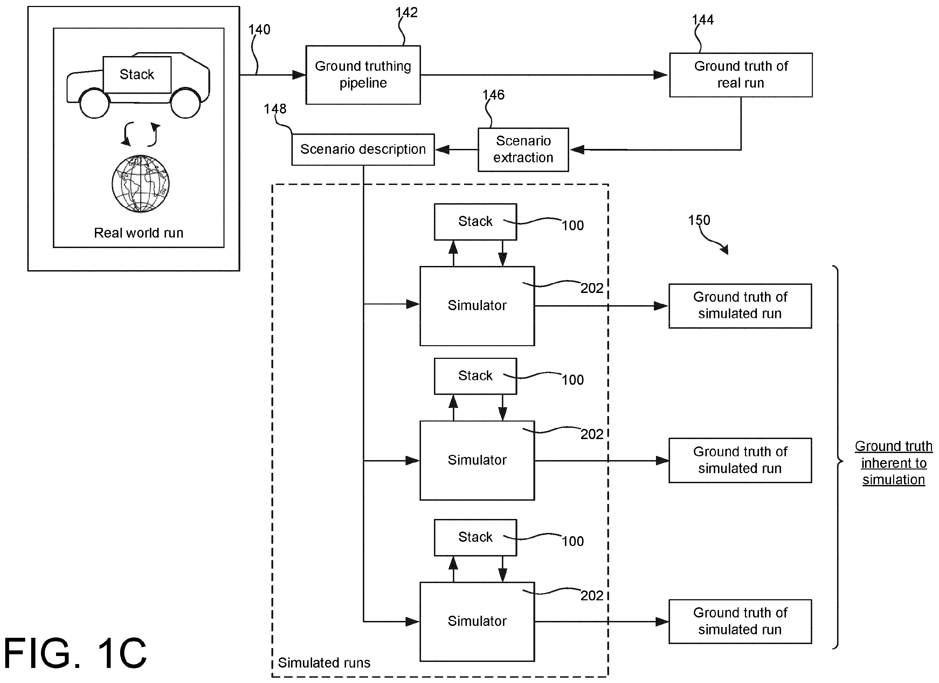

Figure 1C shows a highly schematic block diagram of a scenario extraction pipeline. Data 140 of a real-world run is passed to a 'ground-truthing' pipeline 142 for the purpose of generating scenario ground truth. The run data 140 could comprise, for example, sensor data and/or perception outputs captured/generated on board one or more vehicles (which could be autonomous, human-driven or a combination thereof), and/or data captured from other sources such external sensors (CCTV etc.). The run data is processed within the ground truthing pipeline 142, in order to generate appropriate ground truth 144 ("trace(s)" and contextual data) for the real-world run. The ground-truthing process could be based on manual annotation of the 'raw' run data 140, or the process could be entirely automated (e.g. using offline perception method(s)), or a combination of manual and automated ground truthing could be used. For example, 3D bounding boxes may be placed around vehicles and/or other agents captured in the run data 140, in order to determine spatial and motion states of their traces. A scenario extraction component 146 receives the scenario ground truth 144, and processes the scenario ground truth 144 to extract a scenario description 148 that can be used for the purpose of simulation. The scenario description 148 is consumed by the simulator 202, allowing multiple simulated runs to be derived therefrom. Ground truth 150 is provided for each simulated run.

The term "perception" generally refers to techniques for perceiving structure in the real-world data 140, such as 2D or 3D bounding box detection, location detection, pose detection, motion detection etc. For example, a trace may be extracted as a time-series of bounding boxes or other spatial states in 3D space or 2D space (e.g. in a birds-eye-view frame of reference), with associated motion information (e.g. speed, acceleration, jerk etc.). In the context of image processing, such techniques are often classed as "computer vision", but the term perception encompasses a broader range of sensor modalities.

### Simulation context

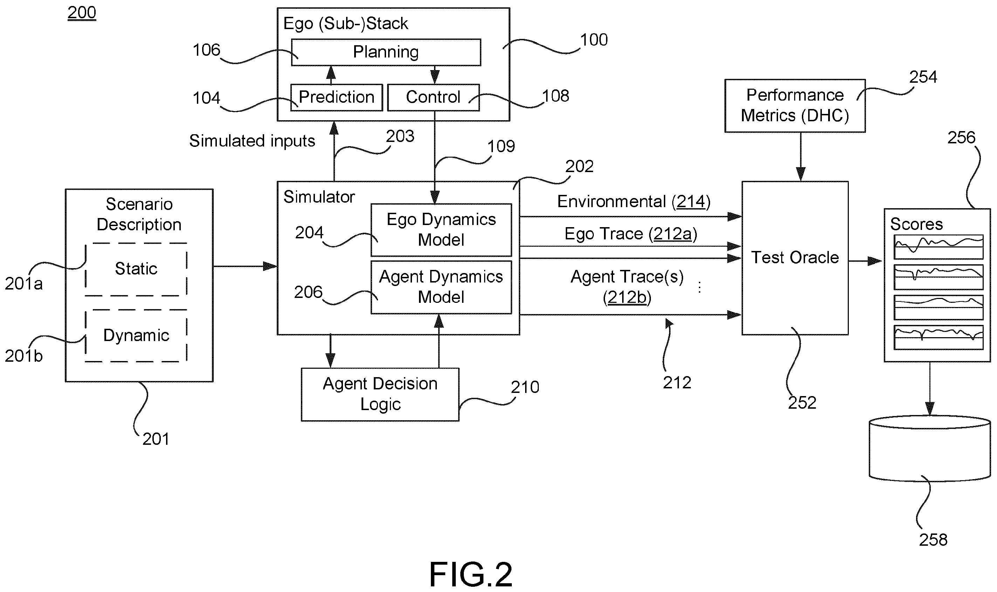

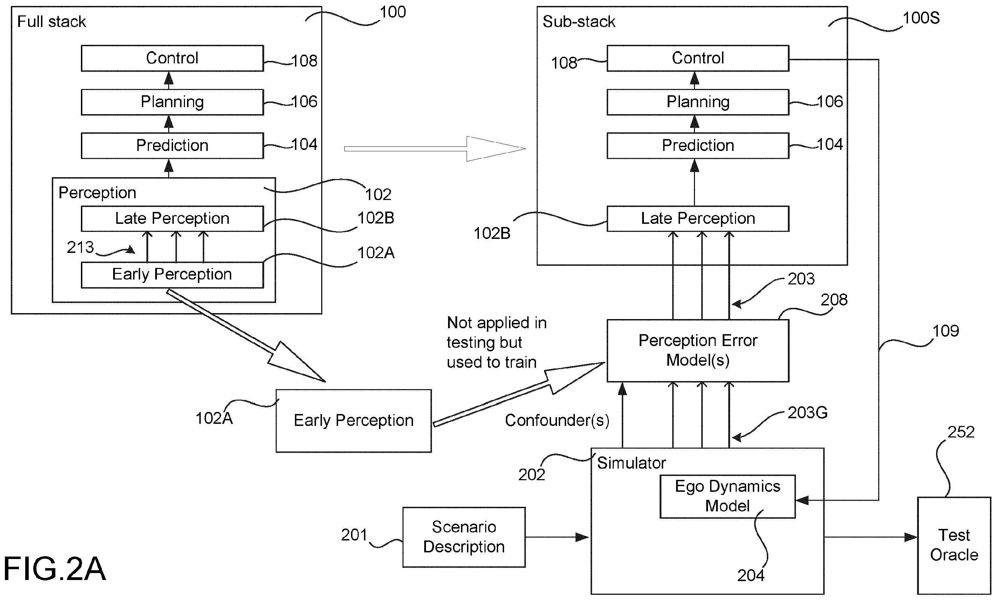

Figure 2 shows a schematic block diagram of a testing pipeline 200. The testing pipeline 200 is shown to comprise a simulator 202 and a test oracle 252. The simulator 202 runs simulated scenarios for the purpose of testing all or part of an AV run time stack, and the test oracle 253 evaluates the performance of the stack (or sub-stack) on the simulated scenarios. The following description refers to the stack of Figure 1A by way of example. However, the testing pipeline 200 is highly flexible and can be applied to any stack or sub-stack operating at any level of autonomy.

The idea of simulation-based testing is to run a simulated driving scenario that an ego agent must navigate under the control of a stack (or sub-stack) being tested. Typically, the scenario includes a static drivable area (e.g. a particular static road layout) that the ego agent is required to navigate in the presence of one or more other dynamic agents (such as other vehicles, bicycles, pedestrians etc.). Simulated inputs feed into the stack under testing, where they are used to make decisions. The ego agent is, in turn, caused to carry out those decisions, thereby simulating the behaviour of an autonomous vehicle in those circumstances.

Simulated inputs 203 are provided to the stack under testing. "Slicing" refers to the selection of a set or subset of stack components for testing. This, in turn, dictates the form of the simulated inputs 203.

By way of example, Figure 2 shows the prediction, planning and control systems 104, 106 and 108 within the AV stack 100 being tested. To test the full AV stack of Figure 1A, the perception system 104 could also be applied during testing. In this case, the simulated inputs 203 would comprise synthetic sensor data that is generated using appropriate sensor model(s) and processed within the perception system 102 in the same way as real sensor data. This requires the generation of sufficiently realistic synthetic sensor inputs (such as photorealistic image data and/or equally realistic simulated lidar/radar data etc.). The resulting outputs of the perception system 102 would, in turn, feed into the higher-level prediction and planning system 104, 106.

By contrast, so-called "planning-level" simulation would essentially bypass the perception system 102. The simulator 202 would instead provide simpler, higher-level inputs 203 directly to the prediction system 104. In some contexts, it may even be appropriate to bypass the prediction system 104 as well, in order to test the planner 106 on predictions obtained directly from the simulated scenario.

Between these extremes, there is scope for many different levels of input slicing, e.g. testing only a subset of the perception system, such as "later" perception components, i.e., components such as filters or fusion components which operate on the outputs from lower-level perception components (such as object detectors, bounding box detectors, motion detectors etc.).

By way of example only, the description of the testing pipeline 200 makes reference to the runtime stack 100 of Figure 1A. As discussed, it may be that only a sub-stack of the run-time stack is tested, but for simplicity, the following description refers to the AV stack 100 throughout. In Figure 2, reference numeral 100 can therefore denote a full AV stack or only sub-stack depending on the context.

Whatever form they take, the simulated inputs 203 are used (directly or indirectly) as a basis for decision-making by the planner 108.

The controller 108, in turn, implements the planner's decisions by outputting control signals 109. In a real-world context, these control signals would drive the physical actor system 112 of AV. In simulation, an ego vehicle dynamics model 204 is used to translate the resulting control signals 109 into realistic motion of the ego agent within the simulation, thereby simulating the physical response of an autonomous vehicle to the control signals 109.

To the extent that external agents exhibit autonomous behaviour/decision making within the simulator 202, some form of agent decision logic 210 is implemented to carry out those decisions and determine agent behaviour within the scenario. The agent decision logic 210 may be comparable in complexity to the ego stack 100 itself or it may have a more limited decision-making capability. The aim is to provide sufficiently realistic external agent behaviour within the simulator 202 to be able to usefully test the decision-making capabilities of the ego stack 100. In some contexts, this does not require any agent decision making logic 210 at all (open-loop simulation), and in other contexts useful testing can be provided using relatively limited agent logic 210 such as basic adaptive cruise control (ACC). One or more agent dynamics models 206 may be used to provide more realistic agent behaviour.

A simulation of a driving scenario is run in accordance with a scenario description 201, having both static and dynamic layers 201a, 201b.

The static layer 201a defines static elements of a scenario, which would typically include a static road layout.

The dynamic layer 201b defines dynamic information about external agents within the scenario, such as other vehicles, pedestrians, bicycles etc. The extent of the dynamic information provided can vary. For example, the dynamic layer 201b may comprise, for each external agent, a spatial path to be followed by the agent together with one or both of motion data and behaviour data associated with the path. In simple open-loop simulation, an external actor simply follows the spatial path and motion data defined in the dynamic layer that is non-reactive i.e. does not react to the ego agent within the simulation. Such open-loop simulation can be implemented without any agent decision logic 210. However, in closed-loop simulation, the dynamic layer 201b instead defines at least one behaviour to be followed along a static path (such as an ACC behaviour). In this case, the agent decision logic 210 implements that behaviour within the simulation in a reactive manner, i.e. reactive to the ego agent and/or other external agent(s). Motion data may still be associated with the static path but in this case is less prescriptive and may for example serve as a target along the path. For example, with an ACC behaviour, target speeds may be set along the path which the agent will seek to match, but the agent decision logic 110 might be permitted to reduce the speed of the external agent below the target at any point along the path in order to maintain a target headway from a forward vehicle.

The output of the simulator 202 for a given simulation includes an ego trace 212a of the ego agent and one or more agent traces 212b of the one or more external agents (traces 212).

A trace is a complete history of an agent's behaviour within a simulation having both spatial and motion components. For example, a trace may take the form of a spatial path having motion data associated with points along the path such as speed, acceleration, jerk (rate of change of acceleration), snap (rate of change of jerk) etc.

Additional information is also provided to supplement and provide context to the traces 212. Such additional information is referred to as "environmental" data 214 which can have both static components (such as road layout) and dynamic components (such as weather conditions to the extent they vary over the course of the simulation). To an extent, the environmental data 214 may be "passthrough" in that it is directly defined by the scenario description 201 and is unaffected by the outcome of the simulation. For example, the environmental data 214 may include a static road layout that comes from the scenario description 201 directly. However, typically the environmental data 214 would include at least some elements derived within the simulator 202. This could, for example, include simulated weather data, where the simulator 202 is free to change weather conditions as the simulation progresses. In that case, the weather data may be time-dependent, and that time dependency will be reflected in the environmental data 214.

The test oracle 252 receives the traces 212 and the environmental data 214, and scores those outputs based on a set of predefined performance rules 254 (metrics) in the manner described below. The scoring is time-based: for each performance metric, the test oracle 252 tracks how the value of that metric (the score) changes over time as the simulation progresses. The test oracle 252 provides an output 256 comprising a score-time plot for each performance metric, as described in further detail later. The output 256 is stored in a test database 258 accessible to an expert user of the system. The metrics 254 are informative to an expert and the scores can be used to identify and mitigate performance issues within the tested stack 100.

The set of predefined performance rules 254 includes a lateral stability rule described herein, and other rules for evaluating an ego agent's driving performance. Other rules could, for example, encode some predefined distance requirement relative to other agents (e.g. a requirement to maintain minimum lateral and longitudinal distances to each other agent), speed restrictions, and other safety-related rules, as well as rules relating to other facets of driving such as comfort or progress towards some defined goal.

### Perception error models

Figure 2A illustrates a particular form of slicing and uses reference numerals 100 and 100S to denote a full stack and sub-stack respectively. It is the sub-stack 100S that would be subject to testing within the testing pipeline 200 of Figure 2.

A number of "later" perception components 102B form part of the sub-stack 100S to be tested and are applied, during testing, to simulated perception inputs 203. The later perception components 102B could, for example, include filtering or other fusion components that fuse perception inputs from multiple earlier perception components.

In the full stack 100, the later perception component 102B would receive actual perception inputs 213 from earlier perception components 102A. For example, the earlier perception components 102A might comprise one or more 2D or 3D bounding box detectors, in which case the simulated perception inputs provided to the late perception components could include simulated 2D or 3D bounding box detections, derived in the simulation via ray tracing. The earlier perception components 102A would generally include component(s) that operate directly on sensor data.

With this slicing, the simulated perception inputs 203 would correspond in form to the actual perception inputs 213 that would normally be provided by the earlier perception components 102A. However, the earlier perception components 102A are not applied as part of the testing, but are instead used to train one or more perception error models 208 that can be used to introduce realistic error, in a statistically rigorous manner, into the simulated perception inputs 203 that are fed to the later perception components 102B of the sub-stack 100 under testing.

Such perception error models may be referred to as Perception Statistical Performance Models (PSPMs) or, synonymously, "PRISMs". Further details of the principles of PSPMs, and suitable techniques for building and training them, may be bound in International Patent Application Nos. PCT/EP2020/073565, PCT/EP2020/073562, PCT/EP2020/073568, PCT/EP2020/073563, and PCT/EP2020/073569, incorporated herein by reference in its entirety. The idea behind PSPMs is to efficiently introduce realistic errors into the simulated perception inputs provided to the sub-stack 102B (i.e. that reflect the kind of errors that would be expected were the earlier perception components 102A to be applied in the real-world). In a simulation context, "perfect" ground truth perception inputs 203G are provided by the simulator, but these are used to derive more realistic perception inputs 203 with realistic error introduced by the perception error models(s) 208.

As described in the aforementioned reference, a PSPM can be dependent on one or more variables representing physical condition(s) ("confounders"), allowing different levels of error to be introduced that reflect different possible real-world conditions. Hence, the simulator 202 can simulate different physical conditions (e.g. different weather conditions) by simply changing the value of a weather confounder(s), which will, in turn, change how perception error is introduced.

The later perception components 102b within the sub-stack 100S process the simulated perception inputs 203 in exactly the same way as they would process the real-world perception inputs 213 within the full stack 100, and their outputs, in turn, drive prediction, planning and control. Alternatively, PSPMs can be used to model the entire perception system 102, including the late perception components 208.

### Lateral Stability Assessor

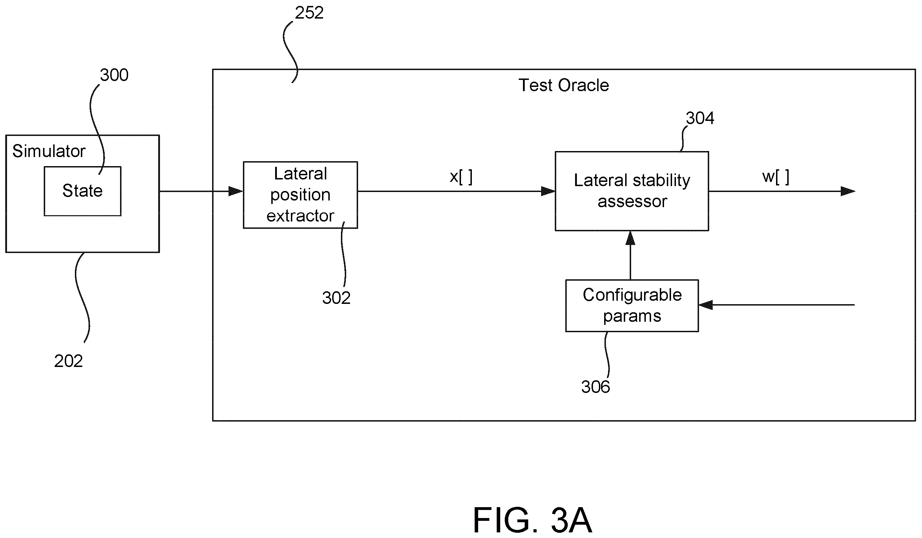

Figure 3A shows a schematic block diagram of a lateral stability assessor 304 within the test oracle 252. The lateral stability assessor 304 is configured to provide a numerical signal, *ω*(*t*), that quantifies the extent to which an ego agent is maintaining a stable lateral position over time (an example of a numerical "lateral stability signal"). To compute the lateral stability signal, e *ω*(*t*), a lateral position extractor 302 extracts a time-varying lateral position signal, *x*(*t*), based on an evolving state 300 of a scenario within the simulator 202. Lateral position is measured between the ego agent and a suitable reference line that generally denotes a direction of travel for the agent, e.g. for a road, lane or other path along which the ego agent is travelling.

The signals can be extracted in "real-time" as the scenario progresses, or they can be extracted "offline" from previously-generated scenario data. Whilst the present example considers simulated scenarios, the techniques can equally be applied to real scenario data, online or offline.

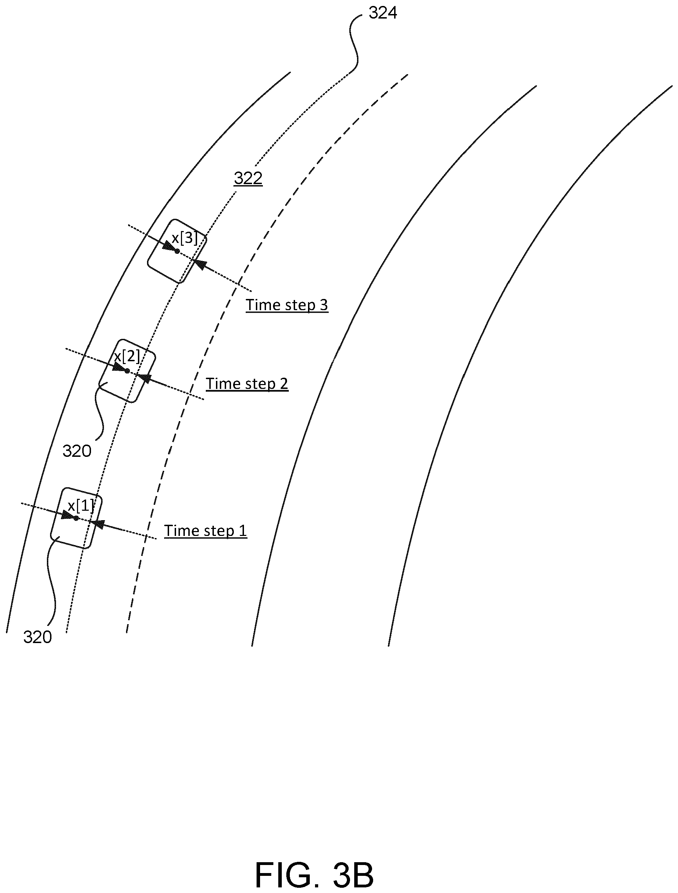

Figure 3B shows an ego agent 320 (real or simulated vehicle) travelling along a lane 322 of a multi-lane road (the ego lane). In this example, the reference line is a center line 324 of the ego lane 322. The ego agent 320 is shown at multiple time steps within the scenario. The lateral position, *x*[*n*], at each time step, *n,* is defined as the lateral displacement between the reference line 324 and a reference point (e.g. center point) of the ego agent 320, in a direction substantially perpendicular to the reference line 324 (lateral direction).

Returning to Figure 3A, in the following examples, the lateral position extractor 302 and lateral stability assessor 304 operate in the digital domain. In the digital domain, the lateral position signal *x*(*t*) and lateral stability signal *ω*(*t*) may be denoted as *x*[ ] and *ω*[ ] respectively.

The lateral position signal *x*[ ] is a digital signal, in the time domain, formed of lateral position measurements over incrementing time steps. Using the terminology of digital signal processing (DSP), the lateral position *x*[*n*] at a given time step *n* may be referred to as a sample of the lateral position signal *x*[*n*]. The same terminology is used in relation to other digital signals, including the lateral stability signal *ω*[ ]. A digital signal has a sample rate, which is the number of samples per second. For example, the sample rate of the lateral position signal, *r*₁, might be of the order of 100Hz (~100 samples per second). In a simulation context, a "full fidelity" signal is obtained when the sample rate *r*₁ matches a rate at which the simulator 202 updates the state 300 of the scenario, as in that case a sample is obtained for every time step within the simulator. However, a lower sample rate can be used if a full fidelity signal is not required.

The lateral stability signal *ω*[ ] is computed via a windowed frequency-domain analysis. For this purpose, the lateral position signal *x*[ ] is transformed into the frequency domain via a windowed Fourier transform (in the example implementation below, the signal is transformed via a Fourier transform with an application of a Hamming window function in the time domain). A sliding window is used to compute an evolving frequency spectrum, and the lateral stability signal *ω*[ ] is computed based on an analysis of the frequency content of the lateral position signal *x*[ ]. This process is described in detail below. For now, suffice it to say that the lateral stability signal *ω*[ ] is a time-domain signal, in which each sample *ω*[*n*] denotes an (overall) energy of any frequency component(s) of the lateral position signal *x*[ ] above a noise floor at the corresponding time step *n*.

In a vehicular context, knowledge of vehicle physics can be used to compute the lateral stability signal *ω*[ ] highly efficiently. A vehicle is typically a large, heavy object. From a DSP perceptive, a vehicle effectively operates as a low pass filter in the following sense. A vehicle is a system that responds to changes in steering angle with changes in lateral position. However, changes to the steering angle above a certain frequency will not generally translate into changes in lateral position of the same frequency because a large, heavy vehicle cannot respond quickly enough to rapid changes in steering angle. It can therefore be deduced that, in practice, most vehicles will not exhibit changes in lateral position above a certain frequency. Moreover, for a vehicle with a conventional front steering system, the lateral motion of the vehicle be mainly determined by its forward motion and the angle of its wheels (following approximately a kinematic single-track bicycle model). As a consequence, the lateral position signal *x*[ ] is expected to be generally sinusoidal, with a frequency that involves relatively slowly. This means that the spectrum of the lateral position signal *x*[ ] within a given window is likely to be mainly dominated by a single peak that, for most vehicles, is unlikely to exceed a certain frequency. More complex steering systems do existing (e.g. with separate front and back steering). Nevertheless, the physical limitations of steering systems, coupled with the properties of most vehicles, will nevertheless restrict the possible frequency content of the lateral position signal *x*[ ] , typically to one or several dominant peaks with amplitudes above a detectable noise floor, and frequencies below some threshold of typically 1-2 Hz or so.

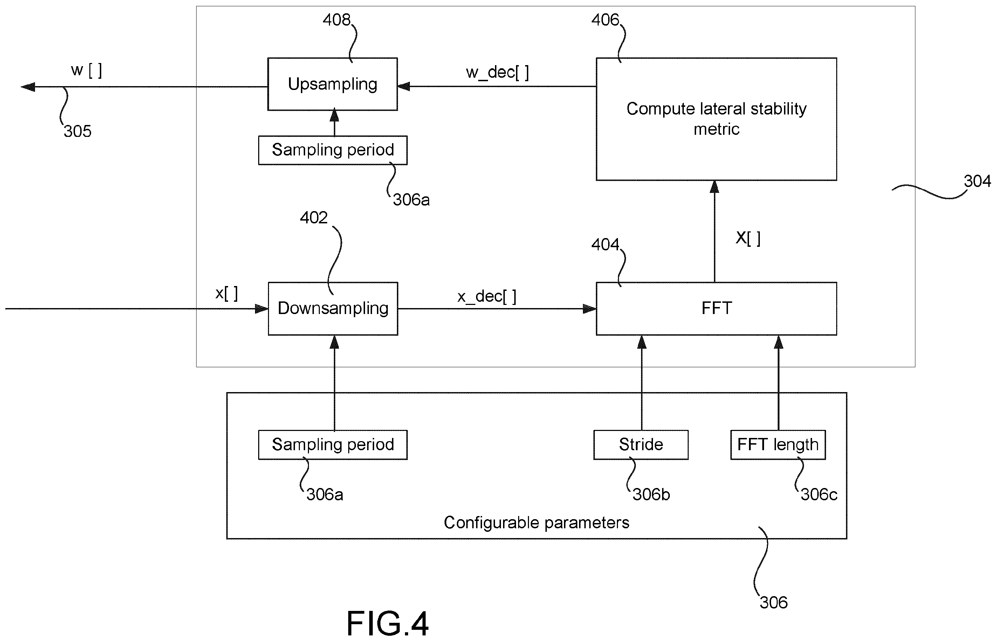

Figure 4 shows an example implementation of the lateral position 304 that significantly reduces the computational burden of the lateral position assessor, without compromising the quality or usefulness of the lateral stability signal *ω*[ ]. This exploits the analysis of the vehicle physics set out above.

The lateral stability assessor 304 can be deployed on real-world data, in an online or offline context. However, the lateral stability assessor 304 can also be deployed as part of simulation-based testing, as in Figure 3A. In a simulation context, it is assumed that an adequately realistic ego vehicle dynamics model 204 is used that will limit the response of a simulated ego agent in a similar manner. Accordingly, the efficient implementation of Figure 4 can be deployed not only on real world signals but also on simulated signals.

Knowing the limitations of the response time of the ego agent and the frequency content of the lateral position signal *x*[ ], two stages of downsampling are applied within the lateral stability assessor 304.

A downsampling component 402 receives the lateral position signal *x*[ ] and implements the first downsampling stage by decimating the signal *x*[ ]. The decimated lateral position signal is denoted *x_{dec}*[ ] and has a reduced sample rate *r*₂. According to the Nyquist theorem, a signal with a given sample rate can fully capture frequency content up to a maximum frequency of one half of the sample rate (the Nyquist frequency). A reduced sample rate of about 10Hz is chosen in the following examples, meaning that the *x_{dec}*[ ] can fully retain the frequency content of the original signal *x*[ ] up to about 5Hz. As discussed above, for most vehicles, any peak(s) in the spectrum are unlikely to exceed 2 Hz or so. A sampling rate of 10Hz therefore implies that any peaks will almost certainly appear in the bottom half of the available spectrum, and the top half of the spectrum (from around 2.5Hz to 5Hz) is therefore assumed to contain only noise. Retaining a noise portion of the spectrum is useful because it allows a noise floor to be easily measured (see below). The decimation includes anti-aliasing filtering io filter-out frequencies above the Nyquist frequency.

It will be appreciated that the numbers given in the previous paragraph are solely for the purpose of illustration. An appropriate sampling rate depends on various factors, including the physical properties of a particular vehicle or system of interest. Indeed, in the present example, the lateral stability assessor 304 has various configurable parameters 306, one of which is a sampling period 306a. The sampling period 306a (*Tᵣ*) defines the reduced sample rate *r*₂ in relation to the original sample rate *r*₁, as *r*₂ = *Tᵣr*₁, e.g. a sampling period of 0.1 implies that *r*₂ is one tenth of *r*₁.

A transformation component 404 receives the decimated signal *x_{dec}*[ ] and computes an evolving frequency spectrum of the decimated signal *x_{dec}*[ ] based on a moving window. In this example, the transformation component 404 applies a fast Fourier transform (FFT) on the decimated signal *x_{dec}*[ ] to which a Hamming window *W*[ ] has been applied. The notation *X_{W}*[*n*] denotes the spectrum as computed at time step *n* within a window *W* (e.g. centered on sample *n).* The output of the transformation component is therefore an evolving spectrum signal *X_{W}*[ ].

The second downsampling stage occurs within the transformation component 404. As discussed above, as well imposing an upper limit on the frequency (or frequency) of spectral peak(s), the physical properties of the vehicle will limit the speed at which that frequency (or those frequencies) can change. If the spectrum were recomputed for every sample of the decimated signal *x_{dec}*[ ], that would mean recomputing the frequency at a rate of *r*₂ (e.g. 10 times per second for *r*₂ = 10Hz). That may be an unnecessary computational burden if the peak frequency (or frequencies) is unlikely to change significantly between samples.

A stride 306b defines how often the spectrum is recomputed in proportion to the reduced sample rate *r*₂: the spectrum is recomputed at a rate of *r*₃ = *Sr*₂, where S is the stride 306b. For example, with a reduced sample rate of *r*₂ = 10Hz and a stride S = 0.1, the spectrum is recomputed at a rate of 1Hz, i.e. once a second.

The stride 306b is also a configurable parameter, as is the size of the window *W* (FFT length 306c). The window size preferably set as a power of two, for example a window size of 128 or 256 samples may be sufficient in practice.

Any suitable windowing function may be used to compute the spectrum at each applicable time step. For example, a hamming window function has been found to yield good results in practice.

A metric computation component 406 computes a decimated lateral stability signal *ω_{dec}*[ ] from the evolving spectrum signal *X*[ ]. An upsampling component 408 then upsamples the decimated lateral stability signal *ω_{dec}*[ ], in order to provide the lateral stability signal *ω*[ ] at the original sample rate *r*₁.

In fact, as explained below, there are two stages of upsampling. The first upsampling stage is implemented as part of the computation of the decimated lateral stability signal *ω*_{dec}[ ], which effectively up-samples from *r*₃ to *r*₂.

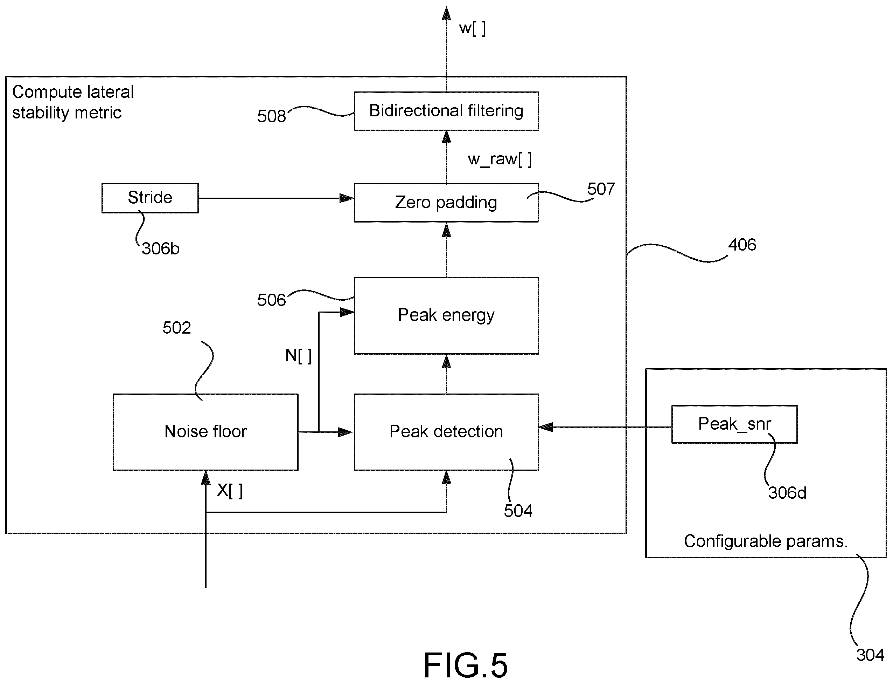

Figure 5 shows further details of the metric computation component 406. The metric computation component 502 receives the evolving spectrum signal *X_{W}*[ ]. A lateral stability metric is computed for each spectrum *X_{W}*[*n*] as follows. A noise floor computation component 502 computes a noise floor *N*[*n*] of the spectrum *X_{W}*[*n*]. As discussed above, the spectrum runs from 0Hz up to the Nyquist frequency (*f_{N}*, e.g. 5Hz) the reduced sample rate *r*₂ is chosen to ensure that any peak(s) within the spectrum *X_{W}*[ ] will almost certainly occur below one half of the Nyquist frequency (0.5*f_{N}*, e.g.2.5Hz). A noise portion of the spectrum ([0.5*f_{N}*, *f_{N}*] in this example) is therefore assumed to contain only noise. The noise floor is measured based on the frequency content of the noise portion of the spectrum, e.g. as an average or maximum amplitude.

A peak detector 504 applies peak detection to each spectrum *X_{W}*[*n*] based on the detected noise floor. Peak detection is implemented by detecting any peak(s) having an amplitude above the noise floor *N*[*n*] or some multiple of the noise floor. In this example, a noise factor (peak_snr) 306d is also a configurable parameter, e.g. with a noise factor of two, peaks are only detected with an amplitude of at least twice the noise floor *N*[*n*].

A peak energy detector computes a "raw" lateral stability metric *ω_{raw}*[*n*] for each applicable time step *n* as an (overall) energy of any detected peak(s) above the noise floor, e.g. as the (sum of) the peak amplitude(s) minus the noise floor *N*[*n*] (i.e. the noise floor subtracted from each peak amplitude; so, with M peaks, the *M* peak amplitudes are summed and *M* * *N*[*n*] is subtracted overall; with no detected peaks, *M* = 0, the metric is zero). Note, the terms energy and amplitude are used interchangeably herein and have units of distance (e.g. meters).

As noted, the spectrum is computed at a rate of *r*₃, therefore peaks are only detected at that rate. To implement the first upsampling stage, zero padding 507 is applied to the raw lateral stability metrics, resulting in a zero-padded raw lateral stability signal *ω_{raw}*[ ] of sample rate *r*₂.

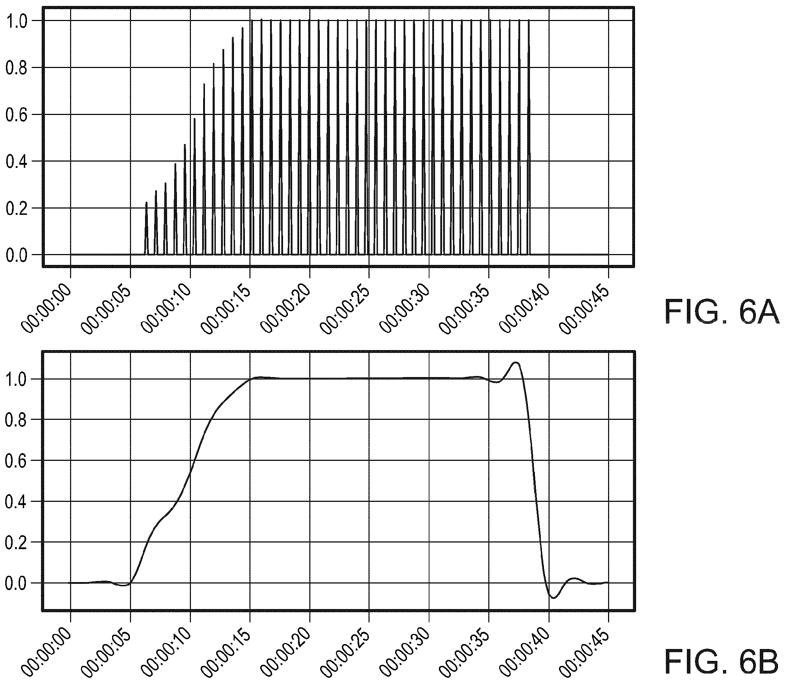

Figure 6A shows an example of a zero-padded raw lateral stability metric signal *ω_{raw}*[ ]. For every time step at which the spectrum is recomputed, the signal is equal to the overall peak energy above the noise floor; for all other time steps, it is zero.

A bidirectional filter 508 is applied to the raw lateral stability metric signal *ω_{raw}*[ ], in order to "smooth" the signal, resulting in the decimated raw lateral stability metric *ω_{dec}*[ ]. Both the raw and decimated lateral stability metric signals *ω_{raw}*[ ], *ω_{dec}*[ ] are at the reduced sample rate of *r*₂; the second upsampling stage is implemented to upsample *ω_{dec}*[ ] to the original sampling rate *r*₁. Bidirectional filtering ensures that the filtered signal *ω_{dec}*[ ] is aligned in time with the raw signal *ω_{raw}*[ ]. Any suitable bidirectional filter can be used. A fourth order Butterworth filter has been found to give good results, but this is merely one example of a suitable filter.

Alternatively a single upsampling stage could be used to up-sample from *r*₃ to *r*₁. A benefit of splitting the upsampling into two stages is that it aligns the sapling stages with the corresponding downsampling stages, and their configurable parameters. As shown in Figure 5, the amount of zero padding introduced in the first stage is determined by the stride 306b of the FFT; likewise, as depicted in Figure 4, the extent of upsampling by the upsampling component 408 is determined by the sampling period 300a applied by the downsampling component 402. In principle, a single stage of upsampling could be applied (even with two stages of downsampling). However, if the up-sampling factor is large (e.g. of the order of 100), then the portion of the spectrum of interest is quite small (1/100); this would require a relatively sharp low pass filter to cut out all mirror spectra caused by the zero-padding, typically a high order filter with many taps that is prone to artefacts. Therefore, it may be possible to improve the quality of the final output by upsampling in stages (e.g. two or more) with more gentle filters.

Figure 6B shows an example of a final lateral stability metric signal *ω*[ ] after upsampling and bidirectional filtering. As can be seen, this is a smooth time-varying signal that quantifies the amount of "lateral stability" exhibited by the ego agent every time step in the scenario in terms of the peak energy above the noise floor.

The rationale of this approach is that lateral stability is related to the frequency domain, i.e. the latter does not exhibit peaks or strong components, or some lateral motion energy for which the sum of all peaks provides a metric. So if this energy or summed amplitude is above a certain threshold, it can be assumed that the vehicle is not laterally stable. It can be seen, therefore, that the lateral stability signal *ω*[ ] usefully quantifies compliance with the qualitative requirement for the ego agent to "maintain a stable lateral position".

The value of the lateral stability signal, *ω*[*n*], at some time step *n* may be referred to as an (instantaneous) lateral stability metric.

Once the lateral stability signal *ω*[ ] has been extracted, a suitable threshold may be applied to determine a binary "pass/fail" signal for lateral stability; the requirement is satisfied (pass) when and only when *ω*[*n*] < *A*. Here, *A* is a maximum permitted amplitude, and has units of distance. For example a threshold *A* of around 0.3 to 0.4 meters may be suitable, but it will be appreciated that this is context-dependent. The threshold A may also be a configurable parameter of the system. The result is a binary signal, *s*[ ], that is TRUE when the threshold condition is satisfied and FALSE otherwise. This binary signal *s*[ ] is an example of a categorical (as opposed to numerical) lateral stability signal. Whilst a binary signal is considered in this example, a non-binary categorical signal may be derived e.g. using multiple threshold conditions and/or other condition(s) that take into account the context of the scenario.

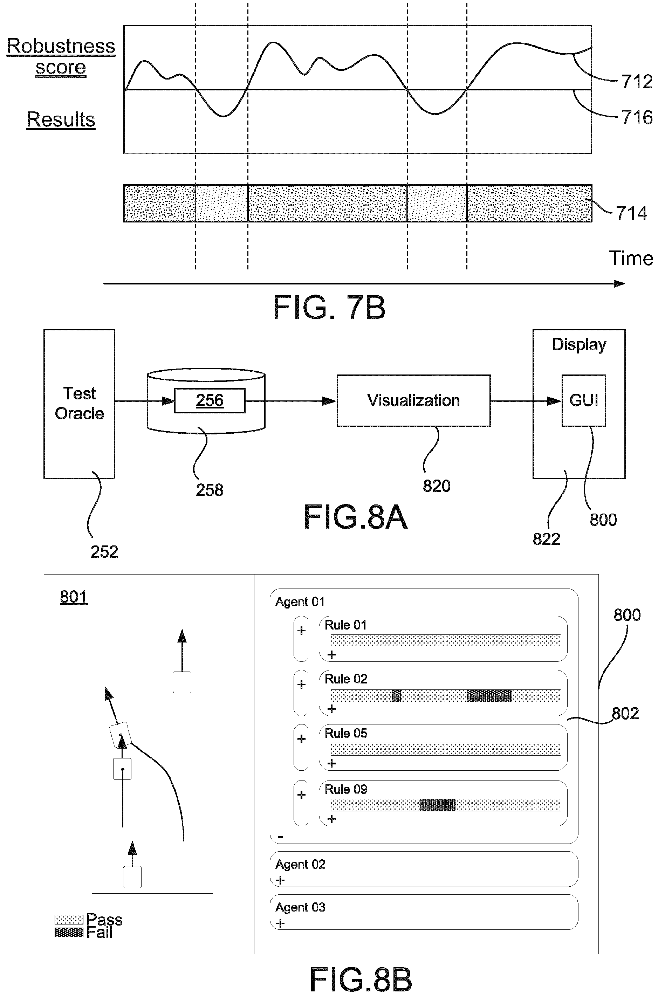

Figure 7 visually depicts an example of a derived numerical signal 712 (the 'robustness score') and a corresponding time-series of results 714 (the binary signal s[] in this case) computed by the lateral stability assessor 304. The results 714 are correlated with the derived signal 312, in that a pass result is returned when (and only when) the derived signal exceeds a failure threshold 716. The derived signal is obtained, in this example, by normalizing and scaling the lateral stability signal w[], e.g. to the range [-1,1] with the threshold A mapped to the desired failure threshold 716 (e.g. zero). When applied with additional driving performance rules, similarly scaled and normalized robustness scores may be computed for those other rules, to allow performance to be readily and meaningfully compared between rules.

Figure 8A shows a schematic block diagram of a visualization component 820. The visualization component 820 is shown having an input connected to the test database 258 for rendering the outputs 256 of the test oracle 252 on a graphical user interface (GUI) 800. The GUI is rendered on a display system 822.

Figure 8B shows an example view of the GUI 800. The view pertains to a particular scenario containing multiple agents, and is shown to comprise a scenario visualization 801 and a set of driving performance assessment results 802, including the lateral stability rule described above. In this example, the test oracle output 526 pertains to multiple external agents, and the results are organized according to agent. For each agent, a time-series of results is available for each rule applicable to that agent (rule timeline). Colour coding is used to differentiate between periods of pass/fail on a particular rule. Each rule timeline is expandible to obtain render a visualization of the robustness score 312 of Figure 7, which may be similarly colour-coded to visually mark pass/fail regions consistent with the rule timeline. In this manner, an expert can systematically assess the performance of the stack 100 (or some portion or portions thereof) across the rule set.

References herein to components, functions, modules and the like, denote functional components of a computer system which may be implemented at the hardware level in various ways. This includes test oracle 252, and the lateral position extractor 302 and lateral stability assessor 304, and the testing pipelines of Figures 2 and 2A more generally. Such components may be implemented in a suitably configured computer system. A computer system comprises one or more computers that may be programmable or non-programmable. A computer comprises one or more processors which carry out the functionality of the aforementioned functional components. A processor can take the form of a general-purpose processor such as a CPU (Central Processing unit) or accelerator (e.g. GPU) etc. or more specialized form of hardware processor such as an FPGA (Field Programmable Gate Array) or ASIC (Application-Specific Integrated Circuit). That is, a processor may be programmable (e.g. an instruction-based general-purpose processor, FPGA etc.) or non-programmable (e.g. an ASIC). Such a computer system may be implemented in an onboard or offboard context in the context of fully/semi-autonomous vehicles and mobile robots.

## Claims

1. A computer implemented method of assessing lateral stability of a moving vehicle in a real or simulated driving scenario, the method comprising:
determining a time-varying lateral position signal for the moving vehicle; the method being **characterized by** comprising:
computing an evolving frequency spectrum of the time-varying lateral position signal over a moving window across the time-varying lateral position signal; and
analysing the evolving frequency spectrum to extract a lateral stability signal that indicates an extent to which the moving vehicle is maintaining a stable lateral position.

2. The method of claim 1, wherein said analysing comprises applying peak detection to the evolving frequency spectrum, the lateral stability signal determined based on an amplitude of any detected peak(s).

3. The method of claim 2, wherein said analysing comprises detecting a noise floor of the evolving frequency spectrum, the lateral stability signal determined based on the amplitude of any detected peak(s) above the noise floor.

4. The method of claim 3, wherein the noise floor is determined based on a noise portion of the spectrum above a frequency threshold.

5. The method of claim 3 or 4, wherein the lateral stability signal is a numerical signal determined as the sum of the amplitude of each peak above the noise floor.

6. The method of any preceding claim, wherein the scenario is simulated, the moving vehicle is controlled in the simulated scenario by a controller (108), and the lateral position signal is determined using a vehicle dynamics model (204) applied to control signals generated by the controller (108).

7. The method of any preceding claim, wherein the time-varying lateral position signal is a digital signal, and the sample rate of the digital time-varying lateral position signal is set based on a response time of the moving vehicle.

8. The method of claim 7 when dependent on claim 6, wherein the response time is determined by the vehicle dynamics model.

9. The method of any of claims 7 to 8, wherein the evolving frequency spectrum is re-computed at a rate less than a sample rate of the time-varying lateral position signal.

10. The method of claim 9, wherein a zero-padded raw lateral stability signal is computed from the evolving frequency spectrum, the lateral stability signal computed by filtering the zero-padded raw lateral stability signal;
wherein the time-varying lateral position signal is computed by downsampling a higher-fidelity lateral position signal, wherein the sample rate of the zero-padded raw lateral stability signal matches the downsampled time-varying lateral position signal, and the lateral stability signal is upsampled to match the sample rate of the higher-fidelity lateral position signal.

11. The method of any preceding claim, wherein the moving window is a moving Hamming window.

12. The method of any preceding claim, applied to test at least part of an autonomous vehicle stack (100) in control of the moving vehicle.

13. The method of claim 12, comprising:
using the lateral stability signal to identify and mitigate a performance issue in said at least part of the autonomous vehicle stack (100).

14. Non-transitory media embodying executable program instructions configured when executed in a computer system to implement the method of any preceding claim.

15. A computer system comprising:
a lateral position extractor (302) configured to provide a time-varying lateral position signal; and
a lateral stability assessor (304) configured to implement the method of any of claims 1 to 13.

## Patentansprüche

1. Computerimplementiertes Verfahren zur Bewertung der seitlichen Stabilität eines sich bewegenden Fahrzeugs in einem realen oder simulierten Fahrszenario, das Verfahren umfassend:
Bestimmen eines zeitlich veränderlichen lateralen Positionssignals für das sich bewegende Fahrzeug;
das Verfahren **gekennzeichnet durch** umfassend:
Berechnen eines sich entwickelnden Frequenzspektrums des sich zeitlich veränderlichen lateralen Positionssignals über ein sich bewegendes Fenster über das sich zeitlich veränderliche laterale Positionssignal; und
Analysieren des sich entwickelnden Frequenzspektrums, um ein Seitenstabilitätssignal zu extrahieren, das anzeigt, inwieweit das sich bewegende Fahrzeug eine stabile laterale Position einnimmt.

2. Verfahren nach Anspruch 1, wobei das Analysieren das Anwenden der Spitzenwerterfassung auf das sich entwickelnde Frequenzspektrum umfasst, wobei das laterale Stabilitätssignal basierend auf einer Amplitude jeder erfassten Spitze(n) bestimmt wird.

3. Verfahren nach Anspruch 2, wobei das Analysieren das Erfassen eines Grundrauschens des sich entwickelnden Frequenzspektrums umfasst, wobei das laterale Stabilitätssignal basierend auf der Amplitude jeder erfassten Spitze(n) oberhalb des Grundrauschens bestimmt wird.

4. Verfahren nach Anspruch 3, wobei das Grundrauschen basierend auf einem Rauschabschnitt des Spektrums oberhalb einer Frequenzschwelle bestimmt wird.

5. Verfahren nach Anspruch 3 oder 4, wobei das Seitenstabilitätssignal ein numerisches Signal ist, das als Summe der Amplitude jeder Spitze über dem Grundrauschen bestimmt wird.

6. Verfahren nach einem der vorstehenden Ansprüche, wobei das Szenario simuliert wird, das sich bewegende Fahrzeug in dem simulierten Szenario von einer Steuerung (108) gesteuert wird und das laterale Positionssignal unter Verwendung eines Fahrzeugdynamikmodells (204) bestimmt wird, das auf von der Steuerung (108) erzeugte Steuersignale angewendet wird.

7. Verfahren nach einem der vorstehenden Ansprüche, wobei das zeitlich veränderliche laterale Positionssignal ein digitales Signal ist und die Abtastrate des digitalen zeitlich veränderlichen lateralen Positionssignals basierend auf einer Reaktionszeit des sich bewegenden Fahrzeugs eingestellt wird.

8. Verfahren nach Anspruch 7 in Abhängigkeit von Anspruch 6, wobei die Reaktionszeit durch das Fahrzeugdynamikmodell bestimmt wird.

9. Verfahren nach einem der Ansprüche 7 bis 8, wobei das sich entwickelnde Frequenzspektrum mit einer Rate neu berechnet wird, die kleiner ist als die Abtastrate des sich zeitlich veränderlichen lateralen Positionssignals.

10. Verfahren nach Anspruch 9, wobei aus dem sich entwickelnden Frequenzspektrum ein mit Nullen gefülltes rohes laterales Stabilitätssignal berechnet wird, wobei das laterale Stabilitätssignal durch Filtern des mit Nullen gefüllten rohen lateralen Stabilitätssignals berechnet wird;
wobei das zeitlich veränderliche laterale Positionssignal durch Abwärtsabtastung eines lateralen Positionssignals mit höherer Genauigkeit berechnet wird, wobei die Abtastrate des mit Null gefüllten rohen lateralen Stabilitätssignals mit dem abwärts abgetasteten zeitlich veränderlichen lateralen Positionssignal übereinstimmt, und das laterale Stabilitätssignal aufwärts abgetastet wird, um mit der Abtastrate des lateralen Positionssignals mit höherer Genauigkeit übereinzustimmen.

11. Verfahren nach einem der vorstehenden Ansprüche, wobei das bewegliche Fenster ein bewegliches Hamming-Fenster ist.

12. Verfahren nach einem der vorstehenden Ansprüche, angewendet zum Testen mindestens eines Teils eines autonomen Fahrzeugstapels (100) bei der Steuerung des sich bewegenden Fahrzeugs.

13. Verfahren nach Anspruch 12, umfassend:
Verwenden des lateralen Stabilitätssignals, um ein Leistungsproblem in dem mindestens einen Teil des autonomen Fahrzeugstapels (100) zu identifizieren und zu mindern.

14. Nichttransitorisches Medium, das ausführbare Programmanweisungen verkörpert, die konfiguriert sind, wenn sie in einem Computersystem ausgeführt werden, um das Verfahren nach einem der vorstehenden Ansprüche zu implementieren.

15. Computersystem, umfassend:
einen lateralen Positionsextraktor (302), der konfiguriert ist, um ein zeitlich veränderliches laterales Positionssignal zu liefern; und
einen lateralen Stabilitätsbeurteiler (304), der konfiguriert ist, um das Verfahren nach einem der Ansprüche 1 bis 13 durchzuführen.

## Revendications

1. Procédé mis en œuvre par ordinateur d'évaluation de la stabilité latérale d'un véhicule en mouvement dans un scénario de conduite réel ou simulé, le procédé comprenant :
la détermination d'un signal de position latérale variable dans le temps pour le véhicule en mouvement ;
le procédé étant **caractérisé en ce qu'**il comprend :
le calcul d'un spectre de fréquences évolutif du signal de position latérale variable dans le temps sur une fenêtre mobile à travers le signal de position latérale variable dans le temps ; et
l'analyse du spectre de fréquences évolutif pour extraire un signal de stabilité latérale qui indique dans quelle mesure le véhicule en mouvement maintient une position latérale stable.

2. Procédé selon la revendication 1, dans lequel ladite analyse comprend l'application d'une détection de pics au spectre de fréquences évolutif, le signal de stabilité latérale étant déterminé sur la base d'une amplitude de tout pic détecté.

3. Procédé selon la revendication 2, dans lequel ladite analyse comprend la détection d'un niveau de bruit du spectre de fréquences évolutif, le signal de stabilité latérale étant déterminé sur la base de l'amplitude de tout pic détecté au-dessus du niveau de bruit.

4. Procédé selon la revendication 3, dans lequel le niveau de bruit est déterminé sur la base d'une partie de bruit du spectre au-dessus d'un seuil de fréquence.

5. Procédé selon la revendication 3 ou 4, dans lequel le signal de stabilité latérale est un signal numérique déterminé comme la somme de l'amplitude de chaque pic au-dessus du niveau de bruit.

6. Procédé selon une quelconque revendication précédente, dans lequel le scénario est simulé, le véhicule en mouvement est commandé dans le scénario simulé par un dispositif de commande (108), et le signal de position latérale est déterminé à l'aide d'un modèle de dynamique de véhicule (204) appliqué aux signaux de commande générés par le dispositif de commande (108).

7. Procédé selon une quelconque revendication précédente, dans lequel le signal de position latérale variable dans le temps est un signal numérique, et la fréquence d'échantillonnage du signal de position latérale variable dans le temps numérique est définie sur la base d'un temps de réponse du véhicule en mouvement.

8. Procédé selon la revendication 7 lorsqu'il dépend de la revendication 6, dans lequel le temps de réponse est déterminé par le modèle de dynamique de véhicule.

9. Procédé selon l'une quelconque des revendications 7 et 8, dans lequel le spectre de fréquences évolutif est recalculé à une fréquence inférieure à une fréquence d'échantillonnage du signal de position latérale variable dans le temps.

10. Procédé selon la revendication 9, dans lequel un signal de stabilité latérale brut complété par des zéros est calculé à partir du spectre de fréquences évolutif, le signal de stabilité latérale étant calculé en filtrant le signal de stabilité latérale brut complété par des zéros ;
dans lequel le signal de position latérale variable dans le temps est calculé en sous-échantillonnant un signal de position latérale de plus haute fidélité, dans lequel la fréquence d'échantillonnage du signal de stabilité latérale brut complété par des zéros correspond au signal de position latérale variable dans le temps sous-échantillonné, et le signal de stabilité latérale est suréchantillonné pour correspondre à la fréquence d'échantillonnage du signal de position latérale de plus haute fidélité.

11. Procédé selon une quelconque revendication précédente, dans lequel la fenêtre mobile est une fenêtre de Hamming mobile.

12. Procédé selon une quelconque revendication précédente, appliqué pour tester au moins une partie d'une pile logicielle de véhicule autonome (100) aux commandes du véhicule en mouvement.

13. Procédé selon la revendication 12, comprenant :
l'utilisation du signal de stabilité latérale pour identifier et atténuer un problème de performance dans ladite au moins une partie de la pile logicielle de véhicule autonome (100).

14. Supports non transitoires contenant des instructions de programme exécutables configurées lorsqu'elles sont exécutées dans un système informatique pour mettre en œuvre le procédé selon une quelconque revendication précédente.

15. Système informatique comprenant :
un extracteur de position latérale (302) configuré pour fournir un signal de position latérale variable dans le temps ; et
un évaluateur de stabilité latérale (304) configuré pour mettre en œuvre le procédé selon l'une quelconque des revendications 1 à 13.
